# EUROPEAN PATENT APPLICATION

(11) **EP 4 571 471 A1**
(43) Date of publication of application: **18.06.2025**
(21) Application number: 24216423.4
(22) Date of filing: 29.11.2024
(51) Int. Cl.: G06F 3/044, H10K 59/122, H10K 59/131, H10K 59/65

(54) **ELECTRONIC DEVICE INCLUDING A LIGHT EMITTING ELEMENT AND A LIGHT SENSING ELEMENT**

(30) Priority: 11.12.2023 KR 20230178308
(71) Applicant: Samsung Display Co., Ltd., Gyeonggi-Do (KR)
(72) Inventor: Yoo, Gi-Na, Yongin-si, Gyeonggi-Do (KR)
(74) Representative: Gulde & Partner

(57) **Abstract**

An electronic device includes a display layer and a reflection prevention layer disposed on the display layer. The display layer includes a first light emitting element having a first light emitting region, a first sensing element adjacent to the first light emitting element and having a first sensing region, a second light emitting element having a second light emitting region, and a second sensing element adjacent to the second light emitting element and having a second sensing region. An area of the first sensing region is greater than an area of the second sensing region.

## Description

### CROSS-REFERENCE TO RELATED APPLICATIONS

This application claims priority to Korean Patent Application No. 10-2023-0178308, filed on December 11, 2023, in the Korean Intellectual Property Office, the disclosure of which is incorporated by reference herein in its entirety.

### TECHNICAL FIELD

The present disclosure relates to an electronic device and, more specifically, to an electronic device including a light emitting element and a light sensing element.

### DISCUSSION OF THE RELATED ART

Electronic devices may incorporate display panels for showing data to a user and a touch sensor for registering a touch of a user, thereby providing an efficient and intuitive means for input and output. Recent electronic devices may additionally be able to sense biometric information or the like provided by the user. Examples of a method of recognizing user information include a capacitance method of sensing a change in a capacitance formed between electrodes, an optical method of sensing an input light using an optical sensor, an ultrasonic method, or the like.

### SUMMARY

An electronic device includes a display layer and a reflection prevention layer disposed on the display layer. The display layer includes a first light emitting element having a first light emitting region, a first sensing element adjacent to the first light emitting element in a first direction and having a first sensing region, a second light emitting element having a second light emitting region, and a second sensing element adjacent to the second light emitting element in the first direction and having a second sensing region. An area of the first sensing region is greater than an area of the second sensing region on a plane defined by the first direction and a second direction intersecting the first direction.

An area of the first light emitting region may be smaller than an area of the second light emitting region.

The first light emitting element may include a first pixel electrode, the second light emitting element may include a second pixel electrode, the first sensing element may include a first sensor electrode, and the second sensing element may include a second sensor electrode. The display layer may further include a pixel defining film partially covering the first pixel electrode, the second pixel electrode, the first sensor electrode, and the second sensor electrode and may include a first opening overlapping the first pixel electrode, a second opening overlapping the second pixel electrode, a third opening overlapping the first sensor electrode, and a fourth opening overlapping the second sensor electrode.

A size of the first opening may be smaller than a size of the second opening, in a plan view.

A size of the third opening may be larger than a size of the fourth opening, in a plan view.

A gap between the first opening and the third opening may be substantially the same as a gap between the second opening and the fourth opening.

The first light emitting region may be defined by the first opening, the second light emitting region may be defined by the second opening, the first sensing region may be defined by the third opening, and the second sensing region may be defined by the fourth opening.

The reflection prevention layer may include a division layer including a first division opening, a second division opening, a third division opening, and a fourth division opening overlapping the first opening, the second opening, the third opening, and the fourth opening in one-to-one correspondence.

A difference between a maximum width of the first division opening and a maximum width of the first opening may be greater than a difference between a maximum width of the second division opening and a maximum width of the second opening.

A distance between the first division opening and the third division opening may be smaller than a distance between the second division opening and the fourth division opening.

The reflection prevention layer may further include a first color filter that covers the first division opening and a second color filter that covers the second division opening, and a thickness of the first color filter may be smaller than a thickness of the second color filter.

The first light emitting element and the second light emitting element may output a light having the same color.

A distance between a center of the first light emitting region and a center of the first sensing region may be substantially the same as a distance between a center of the second light emitting region and a center of the second sensing region.

The display layer may further include a sensor driving circuit electrically connected to the first sensing element, and the second sensing element may be a dummy element.

An electronic device includes a display layer, and a reflection prevention layer disposed on the display layer. The display layer includes a first pixel electrode, a second pixel electrode, a first sensor electrode adjacent to the first pixel electrode in a first direction, a second sensor electrode adjacent to the second pixel electrode in the first direction, and a pixel defining film that partially covers the first pixel electrode, the second pixel electrode, the first sensor electrode, and the second sensor electrode and includes a first opening overlapping the first pixel electrode, a second opening overlapping the second pixel electrode, a third opening overlapping the first sensor electrode, and a fourth opening overlapping the second sensor electrode. A size of the third opening is larger than a size of the fourth opening on a plane defined by the first direction and a second direction intersecting the first direction.

A size of the first opening may be smaller than a size of the second opening, in a plan view.

A gap between the first opening and the third opening may be substantially the same as a gap between the second opening and the fourth opening.

The reflection prevention layer may include a division layer including a first division opening, a second division opening, a third division opening, and a fourth division opening overlapping the first opening, the second opening, the third opening, and the fourth opening in one-to-one correspondence.

A difference between a maximum width of the first division opening and a maximum width of the first opening may be greater than a difference between a maximum width of the second division opening and a maximum width of the second opening, and a distance between the first division opening and the third division opening may be smaller than a distance between the second division opening and the fourth division opening.

The reflection prevention layer may further include a first color filter that covers the first division opening and a second color filter that covers the second division opening, and a thickness of the first color filter may be smaller than a thickness of the second color filter.

An electronic device includes a display panel including a first light emitting element having a first light emitting region, a first sensing element adjacent to the first light emitting element in a first direction and having a first sensing region, a second light emitting element having a second light emitting region, and a second sensing element adjacent to the second light emitting element in the first direction and having a second sensing region. An area of the first sensing region is greater than an area of the second sensing region on a plane defined by the first direction and a second direction intersecting the first direction, and a fingerprint or external illumination is sensed using the first sensing element.

Brightness of an image displayed on the display panel may be adjusted according to external illumination.

### BRIEF DESCRIPTION OF THE FIGURES

The above and other objects and features of the present disclosure will become apparent by describing in detail embodiments thereof with reference to the accompanying drawings.
FIG. 1 is a perspective view of an electronic device according to an embodiment of the present disclosure.
FIG. 2 is a block diagram of the electronic device according to an embodiment of the present disclosure.
FIG. 3 is a block diagram illustrating a display layer and a display driver according to an embodiment of the present disclosure.
FIG. 4 is an equivalent circuit diagram of a pixel and a sensor according to an embodiment of the present disclosure.
FIG. 5A is a cross-sectional view of the electronic device according to an embodiment of the present disclosure.
FIG. 5B is a schematic cross-sectional view of a portion of the display layer according to an embodiment of the present disclosure.
FIG. 6A is a plan view illustrating components of the electronic device according to an embodiment of the present disclosure.
FIG. 6B is a plan view illustrating components of the electronic device according to an embodiment of the present disclosure.
FIG. 7A is a schematic cross-sectional view of the electronic device according to an embodiment of the present disclosure.
FIG. 7B is a schematic cross-sectional view of the electronic device according to an embodiment of the present disclosure.
FIG. 8 is a plan view of components of the electronic device according to an embodiment of the present disclosure.
FIG. 9 is a plan view illustrating components of the electronic device according to an embodiment of the present disclosure.
FIG. 10 is a block diagram illustrating the display layer and the display driver according to an embodiment of the present disclosure.
FIG. 11 is a plan view of components of the electronic device according to an embodiment of the present disclosure.

### DETAILED DESCRIPTION

In the specification, the expression that a first component (or area, layer, part, portion, etc.) is "on", "connected with", or "coupled to" a second component means that the first component is directly on, connected with, or coupled to the second component or means that a third component is disposed therebetween.

The same reference numerals may refer to the same components throughout the specification and the drawings. The expression "and/or" includes one or more combinations which associated components are capable of defining.

Although the terms "first", "second", etc. may be used to describe various components, the components should not necessarily be limited by the terms. The terms are used to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

Also, the terms "under", "below", "on", "above", etc. are used to describe the correlation of components illustrated in drawings. The terms that are relative in concept are described based on a direction illustrated in drawings.

It will be understood that the terms "include", "comprise", "have", etc. specify the presence of features, numbers, steps, operations, elements, or components, described in the specification, or a combination thereof, and do not exclude in advance the presence or additional possibility of one or more other features, numbers, steps, operations, elements, or components or a combination thereof.

Terms "part" and "unit" mean a software component or a hardware component that performs a specific function. The hardware component may include, for example, a fieldprogrammable gate array (FPGA) or an application-specific integrated circuit (ASIC). The software component may refer to an executable code and/or data used by the executable code in an addressable storage medium. Thus, the software components may be, for example, objectoriented software components, class components, and task components, and may include processes, functions, attributes, procedures, subroutines, program code segments, drivers, firmware, microcode, circuits, data, database, data structures, tables, arrays, or variables.

Hereinafter, embodiments of the present disclosure will be described with reference to the accompanying drawings.

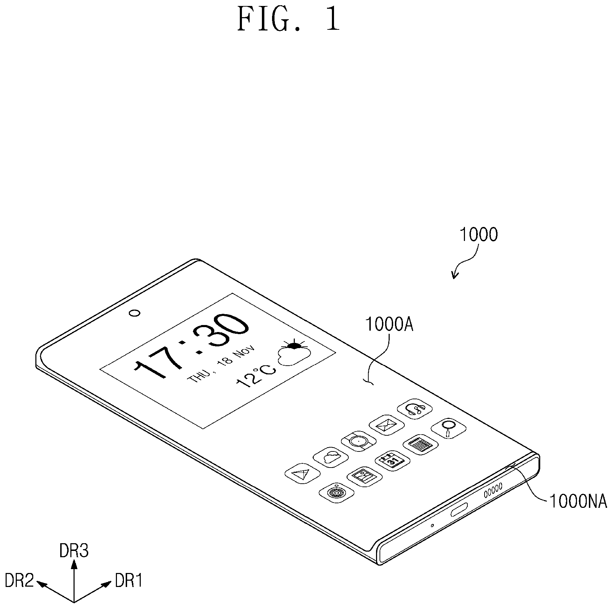

FIG. 1 is a perspective view of an electronic device 1000 according to an embodiment of the present disclosure.

Referring to FIG. 1, the electronic device 1000 may be a device that is activated according to an electric signal. For example, the electronic device 1000 may include a mobile phone (such as a foldable mobile phone), a notebook computer, a television, a tablet computer, an automotive navigation system, a portable game console, or a wearable device, but the present disclosure is not necessarily limited thereto. An example in which the electronic device 1000 is a mobile phone is illustrated in FIG. 1.

An active region 1000A and a peripheral region 1000NA may be defined in the electronic device 1000. The electronic device 1000 may display an image through the active region 1000A. The active region 1000A may include a surface defined by a first direction DR1 and a second direction DR2. The peripheral region 1000NA may surround the active region 1000A on two or more sides thereof. In an embodiment of the present disclosure, the peripheral region 1000NA may be omitted.

A thickness direction of the electronic device 1000 may be a third direction DR3 intersecting the first direction DR1 and the second direction DR2. Thus, front surfaces (or upper surfaces) and rear surfaces (or lower surfaces) of elements constituting the electronic device 1000 may be defined based on the third direction DR3.

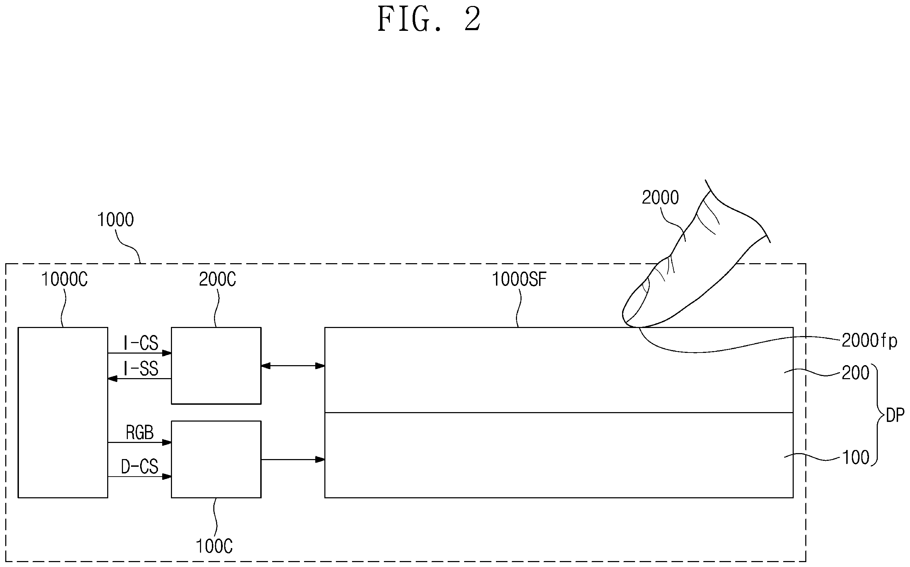

FIG. 2 is a block diagram of the electronic device 1000 according to an embodiment of the present disclosure.

Referring to FIG. 2, the electronic device 1000 may include a display panel DP, a display driver 100C, a sensor driver 200C, and a main driver 1000C. The display panel DP may include a display layer 100 and a sensor layer 200.

The display layer 100 may be a component that substantially generates an image. The display layer 100 may be a light-emitting display layer. For example, the display layer 100 may be an organic light-emitting diode (OLED) display layer, an inorganic light-emitting display layer, an organic-inorganic light emitting display layer, a quantum dot display layer, a micro-light emitting diode (LED) display layer, or a nano-LED display layer. Further, the display layer 100 may include a sensor that senses or reacts to a light reflected by a user fingerprint 2000fp.

The sensor layer 200 may be disposed on the display layer 100. The sensor layer 200 may sense an external input 2000 applied from the outside, for example, from a surface 1000SF of the electronic device 1000. The external input 2000 may include all input means capable of providing a change in capacitance. For example, the sensor layer 200 may sense even an input applied by an active-type input unit providing a driving signal, in addition to a passive-type input unit such as a body of the user.

The main driver 1000C may control an overall operation of the electronic device 1000. For example, the main driver 1000C may control operations of the display driver 100C and the sensor driver 200C. The main driver 1000C may include at least one microprocessor, and may further include a graphic processor. The main driver 1000C may be referred to as an application processor, a central processing unit, or a main processor.

The display driver 100C may drive the display layer 100. The display driver 100C may receive image data RGB and a control signal D-CS from the main driver 1000C. The control signal D-CS may include various signals. For example, the control signal D-CS may include an input vertical synchronization signal, an input horizontal synchronization signal, a main clock, a data enable signal, and the like. The display driver 100C may generate a vertical synchronization signal and a horizontal synchronization signal for controlling the timing to provide a signal to the display layer 100, based on the control signal D-CS.

The sensor driver 200C may drive the sensor layer 200. The sensor driver 200C may receive a control signal I-CS from the main driver 1000C. The control signal I-CS may include a mode determining signal and a clock signal for determining a driving mode of the sensor driver 200C.

The sensor driver 200C may calculate information on coordinates of an input based on a signal received from the sensor layer 200 and may provide a coordinate signal I-SS having the information on the coordinates to the main driver 1000C. The main driver 1000C executes an operation corresponding to the input of the user based on the coordinate signal I-SS. For example, the main driver 1000C may drive the display driver 100C such that a new application image is displayed in the display layer 100.

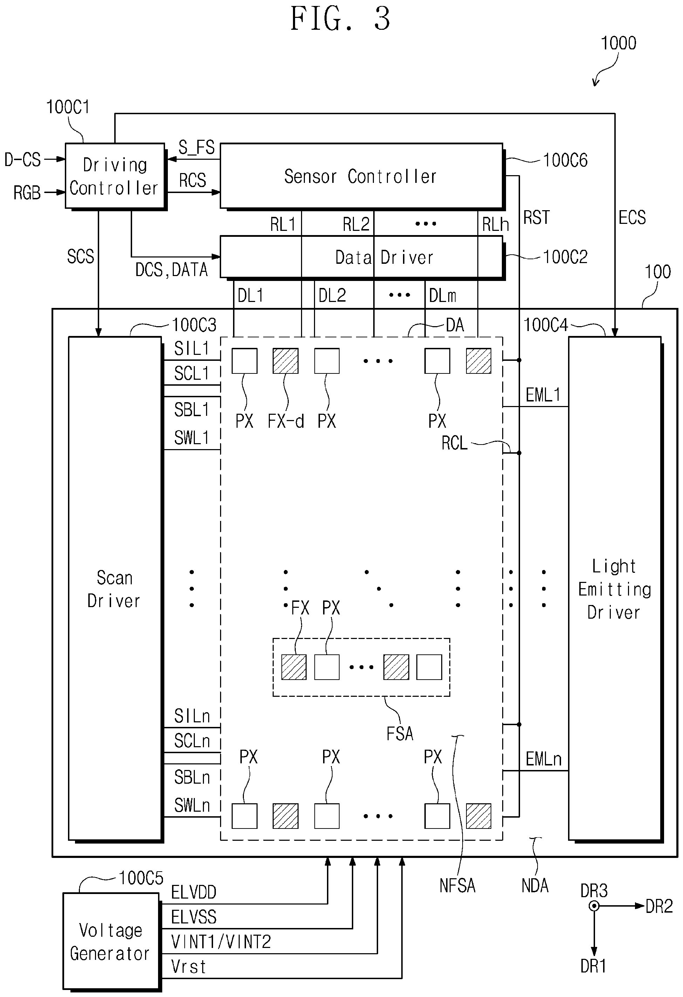

FIG. 3 is a block diagram illustrating the display layer 100 and the display driver100C according to an embodiment of the present disclosure.

Referring to FIGS. 2 and 3, the display driver 100C may include a driving controller 100C1, a data driver 100C2, a scan driver 100C3, a light emitting driver 100C4, a voltage generator 100C5, and a sensor controller 100C6.

The display layer 100 may include a display region DA corresponding to the active region 1000A (see FIG. 1) and a non-display region NDA corresponding to the peripheral region 1000NA (see FIG. 1). The display region DA may include a fingerprint sensing region FSA and a fingerprint non-sensing region NFSA.

The display layer 100 may include a plurality of pixels PX arranged in the display region DA, a plurality of sensors FX arranged in the fingerprint sensing region FSA, and a plurality of dummy sensors FX-d arranged in the fingerprint non-sensing region NFSA. The display layer 100 may further include initialization scan lines SIL1 to SILn, compensation scan lines SCL1 to SCLn, writing scan lines SWL1 to SWLn, black scan lines SBL1 to SBLn, light emitting control lines EML1 to EMLn, data lines DL1 to DLm, and readout lines RL1 to RLh. Herein, m, n and h are integers larger than zero.

The initialization scan lines SIL1 to SILn, the compensation scan lines SCL1 to SCLn, the writing scan lines SWL1 to SWLn, the black scan lines SBL1 to SBLn, and the light emitting control lines EML1 to EMLn extend in the second direction DR2. The initialization scan lines SIL1 to SILn, the compensation scan lines SCL1 to SCLn, the writing scan lines SWL1 to SWLn, the black scan lines SBL1 to SBLn, and the light emitting control lines EML1 to EMLn are spaced apart from each other in the first direction DR1. The data lines DL1 to DLm and the readout lines RL1 to RLh extend in the first direction DR1 and are spaced apart from each other in the second direction DR2.

The plurality of pixels PX are electrically connected to the initialization scan lines SIL1 to SILn, the compensation scan lines SCL1 to SCLn, writing scan lines SWL1 to SWLn, the black scan lines SBL1 to SBLn, the light emitting control lines EML1 to EMLn, and the data lines DL1 to DLm. For example, each of the plurality of pixels PX may be electrically connected to four scan lines. However, the number of scan lines connected to each pixel PX is not necessarily limited thereto and may be changed.

The plurality of sensors FX are electrically connected to the readout lines RL1 to RLh, respectively. One sensor FX may be electrically connected to one scan line, for example, one writing scan line among the writing scan lines SWL1 to SWLn. However, the present disclosure is not necessarily limited thereto. The number of scan lines connected to each sensor FX may change. As an example of the present disclosure, the number of readout lines RL1 to RLh may correspond to a half of the number of data lines DL1 to DLm. However, the present disclosure is not necessarily limited thereto. Alternatively, the number of readout lines RL1 to RLh may correspond to a quarter or an eighth of the number of data lines DL1 to DLm.

In an embodiment of the present disclosure, the dummy sensors FX-d may be provided in the fingerprint non-sensing region NFSA to reduce a difference between the amount of external light reflected in the fingerprint sensing region FSA and the amount of external light reflected in the fingerprint non-sensing region NFSA. The dummy sensors FX-d may be sensors that are not actually operated to acquire fingerprint information of the user. For example, each of the dummy sensors FX-d may include a dummy element and might not include a dummy circuit for driving the dummy element. However, this is an example, and the present disclosure is not necessarily particularly limited thereto. For example, each of the dummy sensors FX-d includes dummy elements and dummy circuits, and the dummy circuits might not be actually operated.

The driving controller 100C1 receives the image data RGB and the control signal D-CS. The driving controller 100C1 generates an image data signal DATA by converting a data format of the image data RGB in compliance with the specification for an interface with the data driver 100C2. The driving controller 100C1 outputs a first control signal SCS, a second control signal ECS, a third control signal DCS, and a fourth control signal RCS.

The data driver 100C2 receives the third control signal DCS and the image data signal DATA from the driving controller 100C1. The data driver 100C2 converts the image data signal DATA into data signals and outputs the data signals to the plurality of data lines DL1 to DLm, which will be described below. A data signal refers to an analog voltage corresponding to a grayscale value of the image data signal DATA.

The scan driver 100C3 receives the first control signal SCS from the driving controller 100C1. The scan driver 100C3 may output scan signals to scan lines in response to the first control signal SCS. For example, in response to the first control signal SCS, the scan driver 100C3 outputs initialization scan signals to the initialization scan lines SIL1 to SILn and may output compensation scan signals to the compensation scan lines SCL1 to SCLn. Further, in response to the first control signal SCS, the scan driver 100C3 may output writing scan signals to the writing scan lines SWL1 to SWLn and may output black scan signals to the black scan lines SBL1 to SBLn.

The scan driver 100C3 may be disposed in the non-display region NDA of the display layer 100. However, the present disclosure is not necessarily particularly limited thereto. For example, at least a portion of the scan driver 100C3 may be disposed in the display region DA.

The light emitting driver 100C4 may be disposed in the non-display region NDA of the display layer 100. The light emitting driver 100C4 receives the second control signal ECS from the driving controller 100C1. The light emitting driver 100C4 may output light emitting control signals to the light emitting control lines EML1 to EMLn in response to the second control signal ECS. Alternatively, the scan driver 100C3 may be connected to the light emitting control lines EML1 to EMLn. In this case, the light emitting driver 100C4 may be omitted, and the scan driver 100C3 may output the light emitting control signals to the light emitting control lines EML1 to EMLn.

The voltage generator 100C5 generates voltages required for an operation of the display layer 100. In an embodiment, the voltage generator 100C5 generates a first driving voltage ELVDD, a second driving voltage ELVSS, a first initialization voltage VINT1, a second initialization voltage VINT2, and a reset voltage Vrst.

The sensor controller 100C6 receives the fourth control signal RCS from the driving controller 100C1.

The sensor controller 100C6 may receive sensing signals from the readout lines RL1 to RLh in response to the fourth control signal RCS. The sensor controller 100C6 may process the sensing signals received from the readout lines RL1 to RLh and provide the processed sensing signals S_FS to the driving controller 100C1.

Each of the sensors FX may receive a light during a predetermined light received period. In an embodiment of the present disclosure, the sensors FX may sense a fingerprint. In an embodiment of the present disclosure, the sensors FX may be used to sense external illumination as well as a fingerprint. For example, when the illumination is sensed using the sensors FX, a wider range of the illumination may be sensed as compared to a case in which an illumination sensor is disposed in a specific region. Further, use convenience and power consumption efficiency of the electronic device 1000 may be increased by adjusting brightness of the image displayed on the display panel DP (see FIG. 2), for example, the display layer 100, according to the sensed illumination.

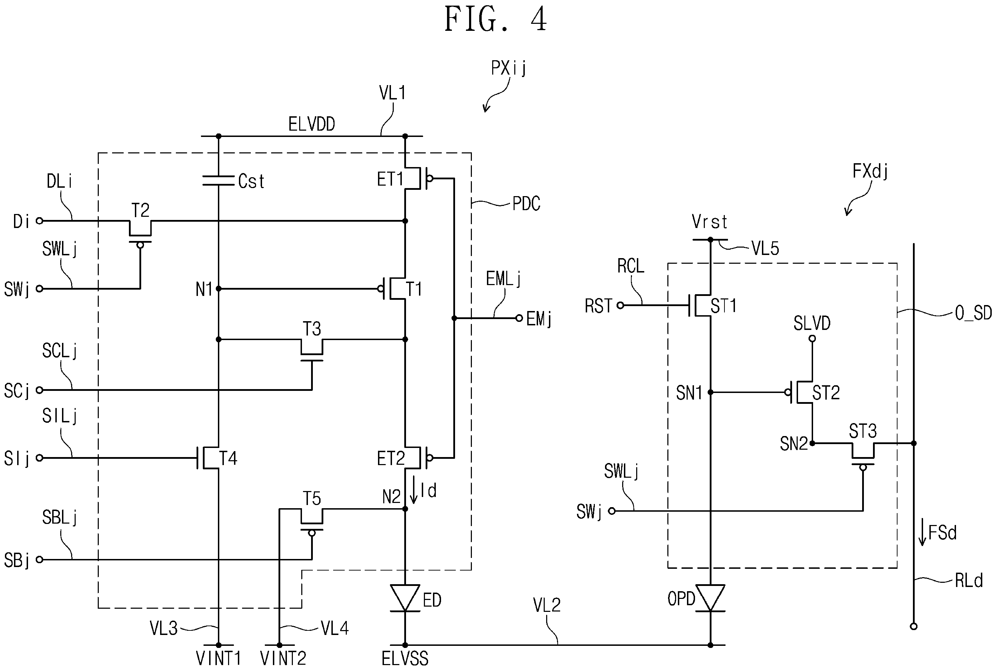

FIG. 4 is an equivalent circuit diagram of a pixel PXij and a sensor FXdj according to an embodiment of the present disclosure.

FIG. 4 illustrates an equivalent circuit diagram of one pixel PXij among the plurality of pixels PX (see FIG. 3). Herein, i is an integer larger than zero and smaller than m or equal to m, and j is an integer larger than zero and smaller than n or equal to n. To the extent that an element is not described in detail with respect to this figure, it may be understood that the element is at least similar to a corresponding element that has been described elsewhere within the present disclosure. For example, the plurality of pixels PX may have the same circuit structure as the pixel PXij. Further, FIG. 4 is an equivalent circuit diagram of one sensor FXdj among the plurality of sensors FX illustrated in FIG. 3. For example, the plurality of sensors FX have the same circuit structure as the sensor FXdj.

Referring to FIGS. 3 and 4, the pixel PXij is connected to an i^{th} data line DLi of the data lines DL1 to DLm, a j^{th} initialization scan line SILj of the initialization scan lines SIL1 to SILn, a j^{th} compensation scan line SCLj of the compensation scan lines SCL1 to SCLn, a j^{th} writing scan line SWLj of the writing scan lines SWL1 to SWLn, a j^{th} black scan line SBLj of the black scan lines SBL1 to SBLn, and a j^{th} light emitting control line EMLj of the light emitting control lines EML1 to EMLn.

The pixel PXij includes a light emitting element ED and a pixel driving circuit PDC. The light emitting element ED may be a light emitting diode (LED). As an example of the present disclosure, the light emitting element ED may be an organic light emitting diode (OLED) including an organic light emitting layer, but the present disclosure is not necessarily particularly limited thereto.

The pixel driving circuit PDC includes first to fifth transistors T1, T2, T3, T4, and T5, first and second light emitting control transistors ET1 and ET2, and one capacitor Cst.

At least one of the first to fifth transistors T1, T2, T3, T4, and T5 and the first and second light emitting control transistors ET1 and ET2 may be a transistor having a low-temperature polycrystalline silicon (LTPS) semiconductor layer. At least one of the first to fifth transistors T1, T2, T3, T4, and T5 and the first and second light emitting control transistors ET1 and ET2 may be a transistor having an oxide semiconductor layer. For example, the third and fourth transistors T3 and T4 may be oxide semiconductor transistors, and the first, second, and fifth transistors T1, 2 and T5 and the first and second light emitting control transistors ET1 and ET2 may be LTPS transistors.

For example, the first transistor T1, which directly affects the brightness of the electronic device 1000 (see FIG. 1), includes a highly reliable polycrystalline silicon semiconductor layer, and therefore, a high-resolution display device may be implemented. Since the oxide semiconductor has high carrier mobility and a low leakage current, a voltage drop is not large even when a driving time is long. For example, since a change in a color of the image due to the voltage drop is not large even during low-frequency driving, the low-frequency driving may be performed. In this way, since the oxide semiconductor has a low leakage current, at least one among the third transistor T3 and the fourth transistor T4 connected to a third electrode (or a gate electrode) of the first transistor T1 may adopt as the oxide semiconductor transistor, and thus leakage current that may flow to the gate electrode may be prevented, and at the same time, power consumption may be reduced.

Some of the first to fifth transistors T1, T2, T3, T4, and T5 and the first and second light emitting control transistors ET1 and ET2 may be P-type transistors, and the others thereof may be N-type transistors. For example, the first, second, and fifth transistors T1, T2, and T5 and the first and second light emitting control transistors ET1 and ET2 may be P-type transistors, and the third and fourth transistors T3 and T4 may be N-type transistors.

A configuration of the pixel driving circuit PDC, according to the present disclosure, is not necessarily limited to an embodiment illustrated in FIG. 4. The pixel driving circuit PDC illustrated in FIG. 4 is only an example, and the configuration of the pixel driving circuit PDC may be modified and implemented. For example, each of the first to fifth transistors T1, T2, T3, T4, and T5 and the first and second light emitting control transistors ET1 and ET2 may be a P-type transistor or an N-type transistor.

The j^{th} initialization scan line SILj, the j^{th} compensation scan line SCLj, the j^{th} writing scan line SWLj, the j^{th} black scan line SBLj, and the j^{th} light emitting control line EMLj may transfer a j^{th} initialization scan signal Slj, a j^{th} compensation scan signal SCj, a j^{th} writing scan signal SWj, a j^{th} black scan signal SBj, and a j^{th} light emitting control signal EMj to the pixel PXij, respectively. The i^{th} data line DLi transmits an i^{th} data signal Di to the pixel PXij. The i^{th} data signal Di may have a voltage level corresponding to the image data RGB (see FIG. 2) input to the electronic device 1000 (see FIG. 2).

First and second driving voltage lines VL1 and VL2 may transmit, to the pixel PXij, the first driving voltage ELVDD and the second driving voltage ELVSS, respectively. Further, first and second initialization voltage lines VL3 and VL4 may respectively transfer the first initialization voltage VINT1 and the second initialization voltage VINT2 to the pixel PXij.

The first transistor T1 is connected between the first driving voltage line VL1 that receives the first driving voltage ELVDD and the light emitting element ED. The first transistor T1 includes a first electrode connected to the first driving voltage line VL1 via the first light emitting control transistor ET1, a second electrode connected to the light emitting element ED via the second light emitting control transistor ET2, and a third electrode (e.g., the gate electrode) connected to one end (e.g., a first node N1) of the capacitor Cst. The first transistor T1 may receive the i^{th} data signal Di transmitted by the i^{th} data line DLi according to a switching operation of the second transistor T2 and supply a driving current Id to the light emitting element ED.

The second transistor T2 is connected between the i^{th} data line DLi and the first electrode of the first transistor T1. The second transistor T2 includes a first electrode connected to the i^{th} data line DLi, a second electrode connected to the first electrode of the first transistor T1, and a third electrode (e.g., the gate electrode) connected to the j^{th} writing scan line SWLj. The second transistor T2 may be turned on according to the j^{th} writing scan signal SWj transmitted through the j^{th} writing scan line SWLj and may transmit the i^{th} data signal Di transmitted from the i^{th} data line DLi to the first electrode of the first transistor T1.

The third transistor T3 is connected between the second electrode of the first transistor T1 and the first node N1. The third transistor T3 includes a first electrode connected to the third electrode of the first transistor T1, a second electrode connected to the second electrode of the first transistor T1, and a third electrode (e.g., the gate electrode) connected to the j^{th} compensation scan line SCLj. The third transistor T3 may be turned on according to the j^{th} compensation scan signal SCj transmitted through the j^{th} compensation scan line SCLj, may connect the third electrode and the second electrode of the first transistor T1 to each other, and thus may diodeconnect the first transistor T1.

The fourth transistor T4 is connected between the first initialization voltage line VL3 to which the first initialization voltage VINT1 is applied and the first node N1. The fourth transistor T4 includes a first electrode connected to the first initialization voltage line VL3 to which the first initialization voltage VINT1 is transmitted, a second electrode connected to the first node N1, and a third electrode (e.g., the gate electrode) connected to the j^{th} initialization scan line SILj. The fourth transistor T4 is turned on according to the j^{th} initialization scan signal Slj transmitted through the j^{th} initialization scan line SILj. The fourth transistor T4 that is turned on transfers the first initialization voltage VINT1 to the first node N1 to initialize a potential of the third electrode of the first transistor T1 (i.e., a potential of the first node N1).

The first light emitting control transistor ET1 includes a first electrode connected to the first driving voltage line VL1, a second electrode connected to the first electrode of the first transistor T1, and a third electrode (e.g., the gate electrode) connected to the j^{th} light emitting control line EMLj.

The second light emitting control transistor ET2 includes a first electrode connected to the second electrode of the first transistor T1, a second electrode connected to the light emitting element ED, and a third electrode (e.g., the gate electrode) connected to the j^{th} light emitting control line EMLj.

The first and second light emitting control transistors ET1 and ET2 are simultaneously turned on depending on the j^{th} light emitting control signal EMj transferred through the j^{th} light emitting control line EMLj. The first driving voltage ELVDD applied through the first light emitting control transistor ET1 that is turned on may be compensated for through the diode-connected first transistor T1 and then may be transferred to the light emitting element ED.

The fifth transistor T5 includes a first electrode connected to the second initialization voltage line VL4 to which the second initialization voltage VINT2 is transmitted, a second electrode connected to the second electrode of the second light emitting control transistor ET2, and a third electrode (e.g., the gate electrode) connected to the j^{th} black scan line SBLj. A voltage level of the second initialization voltage VINT2 may be smaller than or equal to that of the first initialization voltage VINT1. The second electrode of the second light emitting control transistor ET2, the second electrode of the fifth transistor T5, and the light emitting element ED may all be electrically connected to a second node N2.

As described above, one end of the capacitor Cst is connected to the third electrode of the first transistor T1, and the other end thereof is connected to the first driving voltage line VL1. A cathode of the light emitting element ED may be connected to the second driving voltage line VL2 that transmits the second driving voltage ELVSS. The second driving voltage ELVSS may have a voltage level that is lower than that of the first driving voltage ELVDD.

The sensor FXdj is connected to a d^{th} readout line RLd among the readout lines RL1 to RLh, the j^{th} writing scan line SWLj (or referred to as an output control line), and a reset control line RCL.

The sensor FXdj includes a sensing element OPD (or referred to as an optical sensing element) and a sensor driving circuit O_SD.

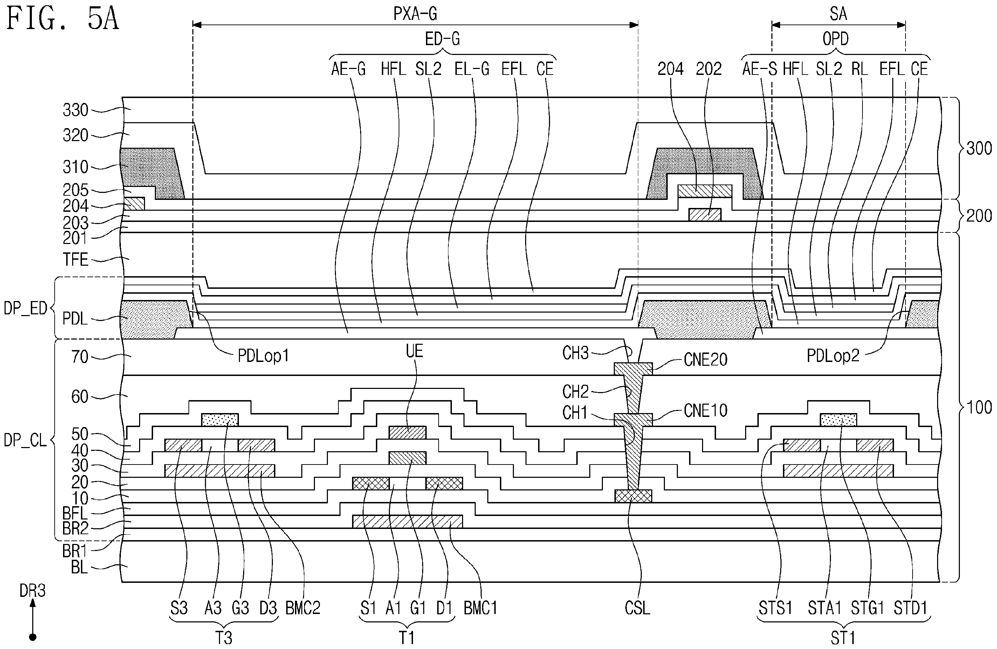

The sensing element OPD may be a photodiode. As an example of the present disclosure, the sensing element OPD may be an organic photodiode including an organic material as a photoelectric conversion layer. A first electrode AE-S (see FIG. 5A) of the sensing element OPD may be connected to a first sensing node SN1, and a second electrode CE (see FIG. 5A) of the sensing element OPD may be connected to the second driving voltage line VL2 that transmits the second driving voltage ELVSS. FIG. 4 illustrates that the sensor FXdj includes one sensing element OPD, but the present disclosure is not necessarily particularly limited thereto. For example, the sensor FXdj may include z sensing elements connected in parallel to each other. Here, z may be an integer of 2 or more. The first electrode AE-S may be referred to as a sensor electrode AE-S.

The sensor driving circuit O_SD includes three transistors ST1, ST2, and ST3. The three transistors ST1, ST2, and ST3 may include the reset transistor ST1, the amplification transistor ST2, and the output transistor ST3. At least one of the reset transistor ST1, the amplification transistor ST2, and the output transistor ST3 may be an oxide semiconductor transistor. As an example of the present disclosure, the reset transistor ST1 may be an oxide semiconductor transistor, and the amplification transistor ST2 and the output transistor ST3 may be LTPS transistors. However, the present disclosure is not necessarily limited thereto. For example, at least the reset transistor ST1 and the output transistor ST3 may be oxide semiconductor transistors, and the amplification transistor ST2 may be an LTPS transistor.

Further, some of the reset transistor ST1, the amplification transistor ST2, and the output transistor ST3 may be P-type transistors, and the other thereof may be N-type transistors. As an example of the present disclosure, the amplification transistor ST2 and the output transistor ST3 may be P-type transistors, and the reset transistor ST1 may be an N-type transistor. However, the present disclosure is not necessarily limited thereto. For example, all the transistors ST1, ST2, and ST3 may be N-type transistors or P-type transistors.

A circuit configuration of the sensor driving circuit O_SD, according to the present disclosure, is not necessarily limited to FIG. 4. The sensor driving circuit O_SD illustrated in FIG. 4 is an example, and a configuration of the sensor driving circuit O_SD may be modified and implemented.

The reset transistor ST1 includes a first electrode that is connected to a third initialization voltage line VL5 and receives the reset voltage Vrst, a second electrode connected to the first sensing node SN1, and a third electrode that receives a reset control signal RST. The reset transistor ST1 may reset a potential of the first sensing node SN1 to the reset voltage Vrst in response to the reset control signal RST. The reset control signal RST may be a signal provided through the reset control line RCL.

The amplification transistor ST2 includes a first electrode that receives a sensing driving voltage SLVD, a second electrode connected to a second sensing node SN2, and a third electrode connected to the first sensing node SN1. The amplification transistor ST2 may be turned on according to the potential of the first sensing node SN1 to apply the sensing driving voltage SLVD to the second sensing node SN2. As an example of the present disclosure, the sensing driving voltage SLVD may correspond to one of the first driving voltage ELVDD and the first and second initialization voltages VINT1 and VINT2.

When the sensing driving voltage SLVD corresponds to the first driving voltage ELVDD, the first electrode of the amplification transistor ST2 may be electrically connected to the first driving voltage line VL1. When the sensing driving voltage SLVD corresponds to the first initialization voltage VINT1, the first electrode of the amplification transistor ST2 may be electrically connected with the first initialization voltage line VL3. When the sensing driving voltage SLVD corresponds to the second initialization voltage VINT2, the first electrode of the amplification transistor ST2 may be electrically connected with the second initialization voltage line VL4.

The output transistor ST3 includes a first electrode connected to the second sensing node SN2, a second electrode connected to the d^{th} readout line RLd, and a third electrode that receives an output control signal. The output transistor ST3 may transmit a sensing signal FSd to the d^{th} readout line RLd in response to the output control signal. The output control signal may be the j^{th} writing scan signal SWj (or referred to as the j^{th} output control signal) supplied through the j^{th} writing scan line SWLj. For example, the output transistor ST3 may receive the j^{th} writing scan signal SWj supplied from the j^{th} writing scan line SWLj as the output control signal.

A reset period may be defined as an activation period (for example, a high level period) of the reset control line RCL. When the reset control signal RST having a high level is supplied through the reset control line RCL, the reset transistor ST1 is turned on. Alternatively, when the reset transistor ST1 is a P-channel metal oxide semiconductor (PMOS) transistor, the reset control signal RST having a low level may be supplied to the reset control line RCL during the reset period. During the reset period, the first sensing node SN1 may be reset to a potential corresponding to the reset voltage Vrst. As an example of the present disclosure, the reset voltage Vrst may have a voltage level lower than that of the second driving voltage ELVSS.

The sensing element OPD of the sensor FXdj may be exposed to light during a light emitting period of the light emitting element ED. A voltage of the first sensing node SN1 is maintained to the reset voltage Vrst during the reset period, and as the sensing element OPD is exposed to light, the voltage of the first sensing node SN1 may be gradually shifted to the second driving voltage ELVSS. The amplification transistor ST2 may be a source follower amplifier that generates a source-drain current in proportion to the amount of charges of the first sensing node SN1, which are input to the third electrode of the amplification transistor ST2.

In an output period, the j^{th} writing scan signal SWj having a low level is supplied to the output transistor ST3 through the j^{th} writing scan line SWLj. When the output transistor ST3 is turned on in response to the j^{th} writing scan signal SWj having a low level, the sensing signal FSd corresponding to the current flowing through the amplification transistor ST2 may be output to the d^{th} readout line RLd.

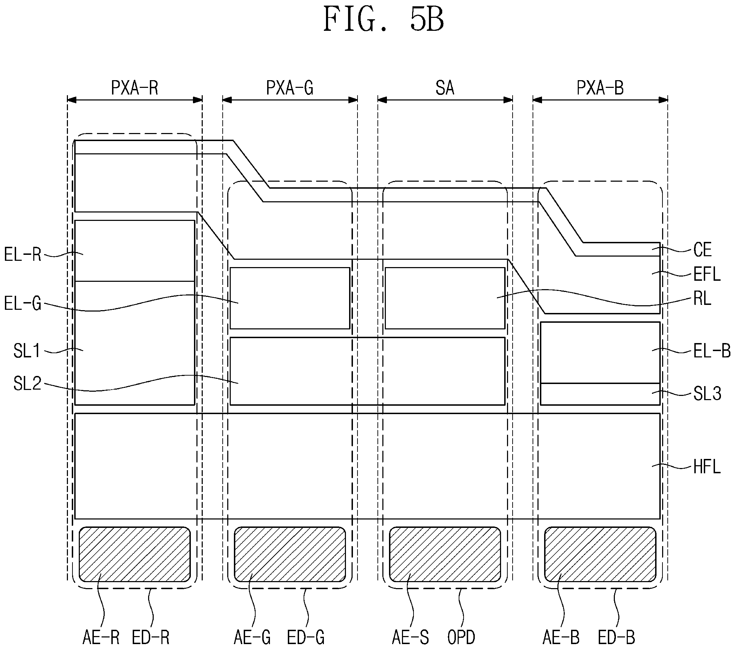

FIG. 5A is a cross-sectional view of the electronic device 1000 according to an embodiment of the present disclosure. FIG. 5B is a schematic cross-sectional view of a portion of the display layer 100 according to an embodiment of the present disclosure.

Referring to FIG. 5A, the display layer 100 may include a base layer BL, a circuit layer DP_CL disposed on the base layer BL, an element layer DP_ED, and an encapsulation layer TFE.

At least one inorganic layer is formed on an upper surface of the base layer BL. The inorganic layer may include an aluminum oxide, a titanium oxide, a silicon oxide, a silicon oxy nitride, a zirconium oxide, and/or a hafnium oxide. The inorganic layer may be formed in multiple layers. The multi-layered inorganic layers may constitute barrier layers BR1 and BR2 and/or a buffer layer BFL, which will be described below. The barrier layers BR1 and BR2 and the buffer layer BFL may be selectively arranged.

The barrier layers BR1 and BR2 prevents foreign substances from being introduced from the outside. The barrier layers BR1 and BR2 may include a silicon oxide layer and a silicon nitride layer. Each of the silicon oxide layer and the silicon nitride layer may be provided in plural, and the silicon oxide layer and the silicon nitride layer may be laminated alternately.

The barrier layers BR1 and BR2 may include the first barrier layer BR1 and the second barrier layer BR2. A first rear metal layer BMC1 may be disposed between the first barrier layer BR1 and the second barrier layer BR2. In an embodiment of the present disclosure, the first rear metal layer BMC1 may be omitted. The first rear metal layer BMC1 may be referred to as a first back metal layer, or a first lower metal layer.

The buffer layer BFL may be disposed on the barrier layers BR1 and BR2. The buffer layer BFL increases a coupling force between the base layer BL and a semiconductor pattern and/or a conductive pattern. The buffer layer BFL may include a silicon oxide layer and a silicon nitride layer. The silicon oxide layer and the silicon nitride layer may be alternately laminated.

A first semiconductor pattern may be disposed on the buffer layer BFL. The first semiconductor pattern may include a silicon semiconductor. For example, the silicon semiconductor may include amorphous silicon, polycrystalline silicon, and the like. For example, the first semiconductor pattern may include low-temperature polysilicon.

FIG. 5A illustrates a portion of the first semiconductor pattern disposed on the buffer layer BFL, and another portion of the first semiconductor pattern may be disposed in another region. The first semiconductor pattern may be disposed across the pixels in a specific rule. The first semiconductor pattern may have a different electrical property depending on whether or not the first semiconductor pattern is doped. The first semiconductor pattern may include a first region of which conductivity is high and a second region of which conductivity is low. The first region may be doped with an N-type dopant or a P-type dopant. A P-type transistor may include a doped region doped with the P-type dopant, and an N-type transistor may include a doped region doped with the N-type dopant. The second region may be a non-doped region or may be a region doped at a concentration that is lower than a concentration of the first region.

A conductivity of the first region is greater than a conductivity of the second region, and the first region may substantially serve as an electrode or a signal line. The second region may substantially correspond to an active region (or a channel) of a transistor. For example, a portion of the semiconductor pattern may be the active region of the transistor, another portion of the semiconductor pattern may be a source region or a drain region of the transistor, and the other portion of the semiconductor pattern may be a connection electrode or a connection signal line.

A first electrode S1, an active region A1, and a second electrode D1 of the first transistor T1 are formed from the first semiconductor pattern. The first electrode S1 and the second electrode D1 of the first transistor T1 extend from the active region A1 in opposite directions on a cross section.

FIG. 5A illustrates a portion of a connection signal line CSL formed from the first semiconductor pattern. The connection signal line CSL may be connected to the second electrode of the fifth transistor T5 (see to FIG. 4) in a plan view.

A first insulating layer 10 may be disposed on the buffer layer BFL. The first insulating layer 10 may overlap a plurality of pixels in common and may cover the first semiconductor pattern. The first insulating layer 10 may be an inorganic layer and/or an organic layer and may have a single-layer structure or a multi-layer structure. The first insulating layer 10 may include aluminum oxide, titanium oxide, silicon oxide, silicon nitride, silicon oxy nitride, zirconium oxide, and/or hafnium oxide. In an embodiment, the first insulating layer 10 may be a single-layer silicon oxide layer. An insulating layer of the circuit layer DP_CL, which will be described below, as well as the first insulating layer 10 may be an inorganic layer and/or an organic layer and may have a single-layer structure or a multi-layer structure. The inorganic layer may include at least one of the above-described materials, but the present disclosure is not necessarily limited thereto.

A third electrode G1 of the first transistor T1 is disposed on the first insulating layer 10. The third electrode G1 may be a portion of a metal pattern. The third electrode G1 of the first transistor T1 overlaps the active region A1 of the first transistor T1. The third electrode G1 of the first transistor T1 may serve as a mask in a process of doping the first semiconductor pattern. The third electrode G1 may include titanium (Ti), silver (Ag), an alloy containing silver, molybdenum (Mo), an alloy containing molybdenum, aluminum (Al), an alloy containing aluminum, aluminum nitride (AIN), tungsten (W), tungsten nitride (WN), copper (Cu), indium tin oxide (ITO), indium zinc oxide (IZO) or the like, but the present disclosure is not necessarily particularly limited thereto.

A second insulating layer 20 may be disposed on the first insulating layer 10 and may cover the third electrode G1 of the first transistor T1. The second insulating layer 20 may be an inorganic layer and/or an organic layer and may have a single-layer structure or a multi-layer structure. The second insulating layer 20 may include silicon oxide, silicon nitride, and/or silicon oxy nitride. In an embodiment, the second insulating layer 20 may have a multi-layer structure including a silicon oxide layer and a silicon nitride layer.

An upper electrode UE and a second rear metal layer BMC2 may be arranged on the second insulating layer 20. The upper electrode UE may overlap the third electrode G1. The upper electrode UE may be a portion of the metal pattern. A portion of the third electrode G1 and the upper electrode UE overlapping the portion of the third electrode G1 may define the capacitor Cst (see FIG. 4). In an embodiment of the present disclosure, the second insulating layer 20 may be replaced with an insulating pattern. In this case, the upper electrode UE may be disposed on the insulating pattern, and the upper electrode UE may serve as a mask that forms the insulating pattern from the second insulating layer 20.

The second rear metal layer BMC2 may correspond to an oxide thin film transistor, for example, a lower portion of the third transistor T3. The second rear metal layer BMC2 may receive a constant voltage or a signal.

A third insulating layer 30 may be disposed on the second insulating layer 20 and may cover the upper electrode UE and the second rear metal layer BMC2. The third insulating layer 30 may have a single-layer structure or a multi-layer structure. For example, the third insulating layer 30 may have a multi-layer structure including a silicon oxide layer and a silicon nitride layer.

The second semiconductor pattern may be disposed on the third insulating layer 30. The second semiconductor pattern may include an oxide semiconductor. The oxide semiconductor may include a plurality of regions that are distinguished depending on whether the metal oxide is reduced. A region (hereinafter, referred to as a reduced region), in which the metal oxide is reduced, has higher conductivity than that of a region (hereinafter, a non-reduced region), in which the metal oxide is not reduced. The reduced region substantially serves as the source region/drain region of the transistor or the signal line. The non-reduced region substantially corresponds to an active region (or a semiconductor region or a channel) of the transistor. For example, the portion of the semiconductor pattern may be the active region of the transistor, another portion thereof may be the source region or the drain region of the transistor, and the other portion thereof may be the connection electrode or the connection signal line.

A first electrode S3, an active region A3, and a second electrode D3 of the third transistor T3 are formed from the second semiconductor pattern. The first electrode S3 and the second electrode D3 include a metal reduced from a metal oxide semiconductor. The first electrode S3 and the second electrode D3 may extend from the active region A3 in opposite directions on a cross section.

A fourth insulating layer 40 may be disposed on the third insulating layer 30. The fourth insulating layer 40 may overlap the plurality of pixels in common and may cover the second semiconductor pattern. The fourth insulating layer 40 may include aluminum oxide, titanium oxide, silicon oxide, silicon nitride, silicon oxy nitride, zirconium oxide, and/or hafnium oxide.

A third electrode G3 of the third transistor T3 is disposed on the fourth insulating layer 40. The third electrode G3 may be a portion of a metal pattern. The third electrode G3 of the third transistor T3 overlaps the active region A3 of the third transistor T3. In a process of reducing the second semiconductor pattern, the third electrode G3 may function as a mask. In an embodiment of the present disclosure, the fourth insulating layer 40 may be replaced with an insulating pattern.

A fifth insulating layer 50 may be disposed on the fourth insulating layer 40 and cover the third electrode G3. The fifth insulating layer 50 may be an inorganic layer.

A first connection electrode CNE10 may be disposed on the fifth insulating layer 50. The first connection electrode CNE10 may be connected to the connection signal line CSL through a first contact hole CH1 passing through the first to fifth insulating layers 10, 20, 30, 40, and 50.

A sixth insulating layer 60 may be disposed on the fifth insulating layer 50. The sixth insulating layer 60 may be an organic layer. The organic layer may include general purpose polymers such as benzocyclobutene (BCB), polyimide, hexamethyldisiloxane (HMDSO), polymethylmethacrylate (PMMA), and polystyrene (PS), a polymer derivative having a phenolic group, an acryl-based polymer, an imide-based polymer, an arylether-based polymer, an amidebased polymer, a fluorine-based polymer, a p-xylene-based polymer, a vinyl alcohol-based polymer, and blends thereof, but the present disclosure is not necessarily particularly limited thereto.

A second connection electrode CNE20 may be disposed on the sixth insulating layer 60. The second connection electrode CNE20 may be connected to the first connection electrode CNE10 through a second contact hole CH2 passing through the sixth insulating layer 60. A seventh insulating layer 70 may be disposed on the sixth insulating layer 60 to cover the second connection electrode CNE20. The seventh insulating layer 70 may be an organic layer.

The circuit layer DP_CL may further include the sensor driving circuit O_SD (see FIG. 4). For convenience of description, the reset transistor ST1 among the sensor driving circuit O_SD is illustrated. A first electrode STS1, an active region STA1, and a second electrode STD1 of the reset transistor ST1 are formed from the second semiconductor pattern. The first electrode STS1 and the second electrode STD1 include a metal reduced from a metal oxide semiconductor. The fourth insulating layer 40 is disposed to cover the first electrode STS1, the active region STA1, and the second electrode STD1 of the reset transistor ST1. A third electrode STG1 of the reset transistor ST1 is disposed on the fourth insulating layer 40. In an embodiment, the third electrode STG1 may be a portion of a metal pattern. The third electrode STG1 of the reset transistor ST1 overlaps the active region STA1 of the reset transistor ST1.

As an example of the present disclosure, the reset transistor ST1 may be disposed on the same layer as the third transistor T3. For example, the first electrode STS1, the active region STA1, and the second electrode STD1 of the reset transistor ST1 may be formed through the same process as the first electrode S3, the active region A3, and the second electrode D3 of the third transistor T3, respectively. The third electrode STG1 of the reset transistor ST1 may be formed simultaneously with the third electrode G3 of the third transistor T3 through the same process. Although not separately illustrated, the first electrodes and the second electrodes of the amplification transistor ST2 and the output transistor ST3 of the sensor driving circuit O_SD may be formed through the same process of the first electrode S1 and the second electrode D1 of the first transistor T1, respectively. Since the reset transistor ST1 and the third transistor T3 may be formed on the same layer through the same process, an additional process for forming the reset transistor ST1 is not required, so that process efficiency may be increased and costs may be reduced.

Referring to FIGS. 5A and 5B together, the element layer DP_ED may be disposed on the circuit layer DP_CL. The element layer DP_ED may include light emitting elements ED-R, ED-G, and ED-B and the sensing elements OPD. The light emitting elements ED-R, ED-G, and ED-B may include the red light emitting element ED-R, the green light emitting element ED-G, and the blue light emitting element ED-B. FIG. 5A representatively illustrates one green light emitting element ED-G and one sensing element OPD.

A red light emitting region PXA-R may be defined to correspond to the red light emitting element ED-R, a green light emitting region PXA-G may be defined to correspond to the green light emitting element ED-G, a blue light emitting region PXA-B may be defined to correspond to the blue light emitting element ED-B, and a sensing region SA may be defined to correspond to the sensing element OPD. Each of the red, green, and blue light emitting regions PXA-R, PXA-G, and PXA-B and the sensing region SA may be defined by a pixel defining film PDL, which will be described below.

The red, green, and blue light emitting elements ED-R, ED-G, and ED-B may include first electrodes AE-R, AE-G, and AE-B, a first functional layer HFL, light emitting layers EL-R, EL-G, and EL-B, a second functional layer EFL, and the second electrode CE. The first electrodes AE-R, AE-G, and AE-B may be referred to as pixel electrodes. The sensing element OPD may include a first electrode AE-S, the first functional layer HFL, a photoelectric conversion layer RL, the second functional layer EFL, and the second electrode CE. The first electrode AE-S may be referred to as a sensor electrode. The first functional layer HFL, the second functional layer EFL, and the second electrode CE may be commonly provided in the pixels PX (see FIG. 3), the sensors FX (see FIG. 3), and the dummy sensors FX-d (see FIG. 3).

Referring to FIG. 5A, the first electrode AE-G of the light emitting element ED-G and the first electrode AE-S of the sensing element OPD are arranged on the seventh insulating layer 70. The first electrode AE-G of the light emitting element ED-G may be connected to the second connection electrode CNE20 through a third contact hole CH3 passing through the seventh insulating layer 70.

The light emitting elements ED-R, ED-G, and ED-B may further include first to third auxiliary layers SL1, SL2, and SL3. In an embodiment of the present disclosure, at least some of the first to third auxiliary layers SL1, SL2, and SL3 may be omitted.

The auxiliary layers SL1, SL2, and SL3 include the first auxiliary layer SL1 disposed in the red light emitting region PXA-R, the second auxiliary layer SL2 commonly disposed in the green light emitting region PXA-G and the sensing region SA, and the third auxiliary layer SL3 disposed in the blue light emitting region PXA-B. The first auxiliary layer SL1 may be disposed between the first functional layer HFL and the red light emitting layer EL-R, and the second auxiliary layer SL2 may be disposed between the first functional layer HFL and the green light emitting layer EL-G and between the first functional layer HFL and the photoelectric conversion layer RL. The third auxiliary layer SL3 may be disposed between the first functional layer HFL and the blue light emitting layer EL-B.

The first to third auxiliary layers SL1, SL2, and SL3 may be provided to control a resonance distance. Thus, thicknesses of the first to third auxiliary layers SL1, SL2, and SL3 may be different from each other. FIG. 5B illustrates that the thickness of the first auxiliary layer SL1 is the greatest and the thickness of the third auxiliary layer SL3 is the smallest, but the present disclosure is not necessarily particularly limited thereto.

According to an embodiment of the present disclosure, the second auxiliary layer SL2 of the sensing element OPD and the second auxiliary layer SL2 disposed in the green light emitting region PXA-G may be formed simultaneously through the same process. For example, the second auxiliary layer SL2 may be formed using a single fine metal mask. Thus, a process time required for manufacturing the electronic device 1000 (see FIG. 1) may be reduced.

The pixel defining film PDL may be disposed on the seventh insulating layer 70 and may cover portions of the first electrodes AE-R, AE-G, AE-B, and AE-S. Thus, the pixel defining film PDL may be partially cover the first electrodes AE-R, AE-G, AE-B, and AE-S. Openings PDLop1 and PDLop2 are provided in the pixel defining film PDL. The plurality of light emitting regions PXA-R, PXA-G, and PXA-B and the plurality of sensing region SA may be defined by the openings PDLop1 and PDLop2.

FIG. 5A illustrates the green light emitting region PXA-G among the plurality of light emitting regions PXA-R, PXA-G, and PXA-B and the one sensing region SA among the plurality of sensing region SA. For example, the green light emitting region PXA-G may be defined by the first region defining opening PDLop1, and the sensing region SA may be defined by the second region defining opening PDLop2. The first region defining opening PDLop1 may expose at least a portion of the first electrode AE-G of the light emitting element ED-G, and the second region defining opening PDLop2 may expose at least a portion of the first electrode AE-S of the sensing element OPD.

In an embodiment of the present disclosure, the pixel defining film PDL may r include a black material. The pixel defining film PDL may include a black organic dye/pigment such as carbon black or aniline black. The pixel defining film PDL may be formed by mixing a blue organic material and a black organic material. The pixel defining film PDL may further include a liquid-repellent organic matter.

The light emitting layer EL-G of the light emitting element ED-G may be disposed in a region corresponding to the first region defining opening PDLop1. The light emitting layer EL-G may generate a predetermined colored light. In an embodiment, the patterned light emitting layers EL-R, EL-G, and EL-B are illustrated, but one light emitting layer may be commonly disposed in the plurality of light emitting regions. In this case, the light emitting layer may generate a white light or a blue light. Further, the light emitting layer may have a multi-layer structure that is referred to as a tandem.

The light emitting layers EL-R, EL-G, and EL-B may include low-molecular organic materials or high-molecular organic materials as light emitting materials. Alternatively, the light emitting layers EL-R, EL-G, and EL-B may include quantum dot materials as light emitting materials. A core of a quantum dot may be selected from a group II-VI compound, a group III-V compound, a group IV-VI compound, a group IV element, a group IV compound, and combinations thereof.

The photoelectric conversion layer RL may be disposed in a region corresponding to the second region defining opening PDLop2. The photoelectric conversion layer RL may include an organic photo-sensing material. The second electrode CE may be disposed on the photoelectric conversion layer RL. The first electrode AE-S and the second electrode CE may receive an electrical signal. The first electrode AE-S and the second electrode CE may receive different signals. Thus, a predetermined electric field may be formed between the first electrode AE-S and the second electrode CE. The photoelectric conversion layer RL generates an electrical signal corresponding to a light input into a sensor FX.

Charges generated in the photoelectric conversion layer RL change the electric field between the first electrode AE-S and the second electrode CE. The amount of charges generated in the photoelectric conversion layer RL may change according to whether a light is input to the sensing element OPD and the amount and intensity of the light input to the sensing element OPD. Accordingly, the electric field formed between the first electrode AE-S and the second electrode CE may change. The sensing element OPD according to the present disclosure may obtain information on a fingerprint of the user through a change in the electric field between the first electrode AE-S and the second electrode CE.

The element layer DP_ED may further include a capping layer disposed on the second electrode CE. The capping layer may serve to increase light emitting efficiency by the principle of constructive interference. The capping layer may include a material having a refractive index of 1.6 or higher for a light having a wavelength of 589 nm. The capping layer may be an organic capping layer including an organic material, an inorganic capping layer including an inorganic material, or a composite capping layer including an organic material and an inorganic material. For example, the capping layer CPL may include carbocyclic compounds, heterocyclic compounds, amine group-containing compounds, porphine derivatives, phthalocyanine derivatives, naphthalocyanine derivatives, alkali metal complexes, alkaline earth metals complexes, or any combination thereof. The carbocyclic compounds, the heterocyclic compounds and the amine group-containing compounds may be optionally substituted with substituents including O, N, S, Se, Si, F, Cl, Br, I, or any combination thereof.

The encapsulation layer TFE is disposed on the element layer DP_ED. The encapsulation layer TFE includes at least an inorganic layer (or encapsulation inorganic layer) or an organic layer (or encapsulation organic layer). In an embodiment of the present disclosure, the encapsulation layer TFE may include two inorganic layers and an organic layer disposed therebetween. According to an embodiment of the present disclosure, an encapsulation layer TFE may include a plurality of inorganic layers and a plurality of organic layers, which are alternately laminated.

An encapsulation inorganic layer protects the light emitting element ED and the sensing element OPD from moisture/oxygen, and an encapsulation organic layer protects the light emitting element ED and the sensing element OPD from foreign substances such as dust particles. The encapsulation inorganic layer may include a silicon nitride layer, a silicon oxynitride layer, a silicon oxide layer, a titanium oxide layer, an aluminum oxide layer, etc., but the present disclosure is not necessarily particularly limited thereto. The encapsulation organic layer may include an acryl-based organic layer, and the present disclosure is not necessarily particularly limited thereto.

The electronic device 1000 (see FIG. 1) may further include the sensor layer 200 and a reflection prevention layer 300.

The sensor layer 200 may be disposed on the display layer 100. The sensor layer 200 may sense an external input applied from an external unit. The external input may be input of a user. The input of the user may include various types of external inputs such as a portion of the body of the user, light, heat, a pen, and pressure. The sensor layer 200 may be referred to as a sensor, an input sensing layer, or an input sensing panel. The sensor layer 200 may include a sensor base layer 201, a first sensor conductive layer 202, an intermediate insulating layer 203, a second sensor conductive layer 204, and a cover insulating layer 205.

The sensor base layer 201 may be directly disposed on the display layer 100. The sensor base layer 201 may be an inorganic layer including silicon nitride, silicon oxy nitride, and/or silicon oxide. Alternatively, the sensor base layer 201 may be an organic layer including an epoxy-based resin, an acrylic-based resin, or an imide-based resin. The sensor base layer 201 may have a single-layer structure or have a multi-layer structure in which layers are laminated in the third direction DR3.

Each of the first sensor conductive layer 202 and the second sensor conductive layer 204 may have a single-layer structure or have a multi-layer structure in which layers are laminated in the third direction DR3.

The sensor conductive layer 202 and 204 having a single-layer structure may include a metal layer or a transparent conductive layer. The metal layer may include molybdenum, silver, titanium, copper, aluminum, or alloys thereof. The transparent conductive layer may include a transparent conductive oxide such as an indium tin oxide, an indium zinc oxide, a zinc oxide, or an indium zinc tin oxide. In addition, the transparent conductive layer may include a conductive polymer such as poly(3,4-ethylenedioxythiophene) (PEDOT), metal nanowire, graphene, or the like.

The sensor conductive layer 202 and 204 having a multi-layer structure may include metal layers. The metal layers may have, for example, a three-layer structure of titanium/aluminum/titanium. The sensor conductive layer 202 and 204 having a multi-layer structure may include at least one metal layer and at least one transparent conductive layer.

The intermediate insulating layer 203 may be disposed between the first sensor conductive layer 202 and the second sensor conductive layer 204. The intermediate insulating layer 203 may include an inorganic film. The inorganic film may include aluminum oxide, titanium oxide, silicon oxide, silicon nitride, silicon oxy nitride, zirconium oxide, and/or hafnium oxide.

Alternatively, the intermediate insulating layer 203 may include an organic film. The organic film may include an acryl-based resin, a methacrylate-based resin, a polyisoprene-based resin, a vinyl-based resin, an epoxy-based resin, a urethane-based resin, a cellulose-based resin, a siloxane-based resin, a polyimide-based resin, a polyamide-based resin, and/or a perylene-based resin.

The cover insulating layer 205 may be disposed on the intermediate insulating layer 203 and cover the second sensor conductive layer 204. The second sensor conductive layer 204 may include a conductive pattern. The cover insulating layer 205 may cover the conductive pattern to reduce or eliminate a probability of causing damage to the conductive pattern in a subsequent process. The cover insulating layer 205 may include an inorganic material. For example, the cover insulating layer 205 may include silicon nitride, but the present disclosure is not necessarily particularly limited thereto. In an embodiment of the present disclosure, the cover insulating layer 205 may be omitted.

The reflection prevention layer 300 may be disposed on the sensor layer 200. The reflection prevention layer 300 may include a division layer 310, a plurality of color filters 320, and a flattening layer 330.

The division layer 310 may overlap the conductive pattern of the second sensor conductive layer 204. The cover insulating layer 205 may be disposed between the division layer 310 and the second sensor conductive layer 204. The division layer 310 may prevent reflection of an external light by the second sensor conductive layer 204. A material forming the division layer 310 is not necessarily particularly limited as long as the material absorbs a light. The division layer 310 is a layer having a black color, and in an embodiment, the division layer 310 may include a black coloring agent. The black coloring agent may include a black dye and a black pigment. The black coloring agent may include carbon black, metal such as chromium, or an oxide thereof. The division layer 310 may be referred to as a light shielding layer or a black matrix.

A plurality of division openings may be defined in the division layer 310. The plurality of division openings may overlap the light emitting layers EL-R, EL-G, and EL-B and the photoelectric conversion layer RL. The color filters 320 may be arranged to correspond to the plurality of division openings. The color filter 320 may transmit a light provided from the light emitting layers EL-R, EL-G, and EL-B overlapping the color filter 320. Alternatively, the light may pass through the color filter 320 and may be provided to the photoelectric conversion layer RL.

FIG 5A illustrates that one color filter 320 is commonly provided in the light emitting layer EL-G and the photoelectric conversion layer RL. However, the present disclosure is not necessarily particularly limited thereto. For example, a color filter for another color other than the green color filter may be disposed on the photoelectric conversion layer RL. Alternatively, the color filter 320 might not be disposed on the photoelectric conversion layer RL.

The flattening layer 330 may cover the division layer 310 and the color filters 320. The flattening layer 330 may include an organic material, and a flat surface may be provided to an upper surface of the flattening layer 330. In an embodiment, the flattening layer 330 may be omitted.

In an embodiment of the present disclosure, the reflection prevention layer 300 may include a reflection adjusting layer instead of the color filters 320. For example, in the illustration of FIG. 5A, the color filters 320 may be omitted, and the reflection adjusting layer may be added to a place in which the color filters 320 are omitted. The reflection adjusting layer may selectively absorb a light having a partial band among a light reflected from an inside of the display layer 100 and/or the electronic device 1000 or a light input from an outside of the display layer 100 and/or the electronic device 1000.

As an example, the reflection adjusting layer absorbs a light having a first wavelength region in a range of 490 nm to 505 nm and a light having a second wavelength region in a range of 585 nm to 600 nm, so that a light transmittance in the first wavelength region and the second wavelength region is 40% or less. The reflection adjusting layer may absorb a light having a wavelength deviating from wavelength ranges of a red light, a green light, and a blue light emitted from the light emitting layers EL-R, EL-G, and EL-B. In this way, the reflection adjusting layer may absorb a light having a wavelength not belonging to the wavelength ranges of the red light, the green light, or the blue light emitted from the light emitting layers EL-R, EL-G, and EL-B, thereby preventing or minimizing a decrease in brightness of the display layer 100 and/or the electronic device 1000. Further, at the same time, degradation of light emitting efficiency of the display layer 100 and/or the electronic device 1000 may be prevented or minimized, and visibility may be increased.

The reflection adjusting layer may be provided as an organic material layer including a dye, a pigment, or a combination thereof. The reflection adjusting layer may include a tetraazaporphyrin (TAP)-based compound, a porphyrin-based compound, a metal porphyrin-based compound, an oxazine-based compound, a squarylium-based compound, a triarylmethanebased compound, a polymethine-based compound, an anthraquinone-based compound, a phthalocyanine-based compound, a perylene-based compound, a xanthene-based compound, a diimmonium-based compound, a dipyrromethene-based compound, a cyanine-based compound, and combinations thereof.

In an embodiment, the reflection adjusting layer may have light transmittance of about 64% to 72%. The light transmittance of the reflection adjusting layer may be adjusted according to the content of the pigment and/or the dye included in the reflection adjusting layer.

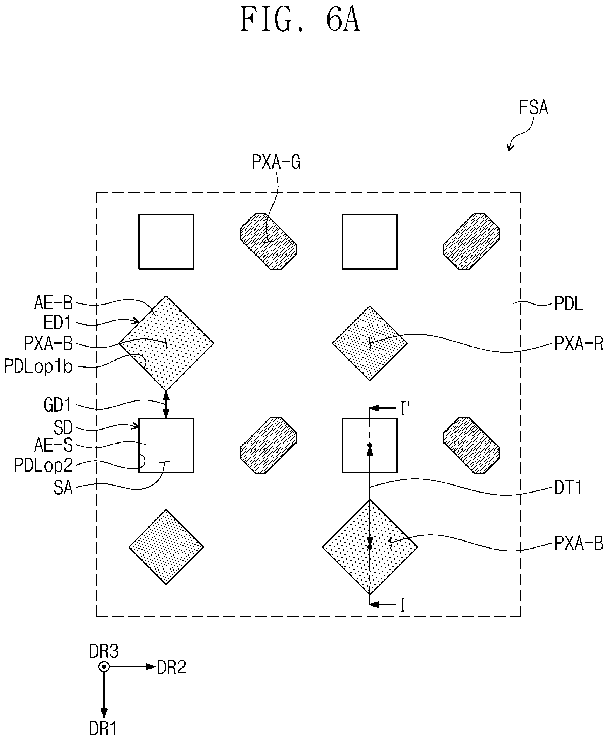

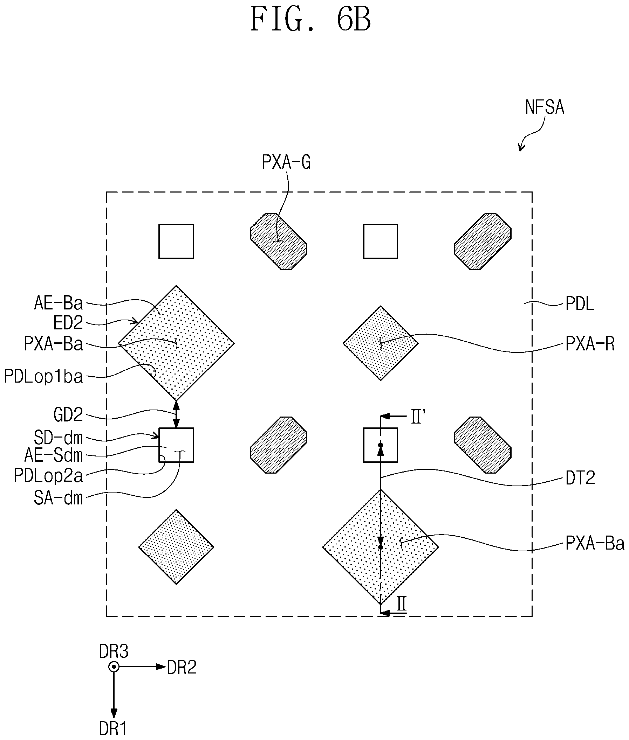

FIG. 6A is a plan view illustrating components of the electronic device 1000 according to an embodiment of the present disclosure. FIG. 6B is a plan view illustrating components of the electronic device 1000 according to an embodiment of the present disclosure. FIG. 6A illustrates the fingerprint sensing region FSA in an enlarged manner, and FIG. 6B illustrates the fingerprint non-sensing region NFSA in an enlarged manner.

Referring to FIGS. 5A, 6A, and 6B, the plurality of first region defining openings PDLop1 may be defined in the pixel defining film PDL. The plurality of light emitting regions PXA-R, PXA-G, PXA-B, and PXA-Ba may be defined by the first region defining openings PDLop1. The plurality of second region defining openings PDLop2 may be defined in the pixel defining film PDL. The plurality of sensing regions SA and SA-dm may be defined by the second region defining openings PDLop2.

The light emitting regions PXA-R, PXA-G, PXA-B, and PXA-Ba may include the first light emitting region PXA-B defined (provided or formed) in the fingerprint sensing region FSA and the second light emitting region PXA-Ba defined in the fingerprint non-sensing region NFSA. The first light emitting region PXA-B and the second light emitting region PXA-Ba may output a light having the same color, for example, the light may be a blue light. Thus, a first pixel including the first light emitting region PXA-B and a second pixel including the second light emitting region PXA-Ba may output a light having the same color.

The first light emitting element ED1 may have the first light emitting region PXA-B, and the second light emitting element ED2 may have the second light emitting region PXA-Ba. For example, the first light emitting element ED1 may include a first pixel electrode AE-B, and the second light emitting element ED2 may include a second pixel electrode AE-Ba. Among the first region defining openings PDLop1, an opening, which overlaps the first pixel electrode AE-B and through which at least a portion of the first pixel electrode AE-B is exposed, is referred to as a first opening PDLop1b. Among the first region defining openings PDLop1, an opening, which overlaps the second pixel electrode AE-Ba and through which at least a portion of the second pixel electrode AE-Ba is exposed, is referred to as a second opening PDLop1ba.

The sensing regions SA and SA-dm may include the first sensing region SA defined in the fingerprint sensing region FSA and the second sensing region SA-dm defined in the fingerprint non-sensing region NFSA. The second sensing region SA-dm may be a region that does not substantially sense the fingerprint and may be referred to as a dummy region.

A first sensing element SD may have the first sensing region SA, and a second sensing element SD-dm may have the second sensing region SA-dm. For example, the first sensing element SD may include the first sensor electrode AE-S, and the second sensing element SD-dm may include a second sensor electrode AE-Sdm. Among the second region defining openings PDLop2, an opening, which overlaps the first sensor electrode AE-S and through which at least a portion of the first sensor electrode AE-S is exposed, is referred to as a third opening PDLop2. Among the second region defining openings PDLop2, an opening, which overlaps the second sensor electrode AE-Sdm and through which at least a portion of the second sensor electrode AE-Sdm is exposed, is referred to as a fourth opening PDLop2a. The first sensing element SD may correspond to the sensing element OPD described in FIG. 4.

The first light emitting element ED1 and the first sensing element SD may be adjacent to each other in the first direction DR1 in the fingerprint sensing region FSA. The second light emitting element ED2 and the second sensing element SD-dm may be adjacent to each other in the first direction DR1 in the fingerprint non-sensing region NFSA.

In an embodiment of the present disclosure, the first sensing element SD in which the first sensing region SA is defined may be an element that is electrically connected to the sensor driving circuit O_SD (see FIG. 4) and senses the fingerprint. The second sensing element SD-dm in which the second sensing region SA-dm is defined might not be an element for substantially sensing a fingerprint. For example, the second sensing element SD-dm may be a dummy element.

In an embodiment of the present disclosure, an area of the first sensing region SA and an area of the second sensing region SA-dm may be different from each other on a plane that is defined by the first direction DR1 and the second direction DR2 intersecting the first direction DR1. For example, the area of the first sensing region SA may be larger than the area of the second sensing region SA-dm. Thus, in a plan view, for example, when viewing in the third direction DR3, a size of the third opening PDLop2 defining the first sensing region SA may be larger than a size of the fourth opening PDLop2a defining the second sensing region SA-dm. In this case, an opening ratio of the first sensing region SA relatively increases, and thus fingerprint sensing sensitivity may be increased.

In an embodiment of the present disclosure, an area of the first light emitting region PXA-B and an area of the second light emitting region PXA-Ba may be different from each other. For example, the area of the first light emitting region PXA-B may be smaller than the area of the second light emitting region PXA-Ba. Thus, a size of the first opening PDLop1b defining the first light emitting region PXA-B may be smaller than a size of the second opening PDLop1ba defining the second light emitting region PXA-Ba.

In an embodiment of the present disclosure, a gap GD1 between the first opening PDLop1b and the third opening PDLop2 may be substantially the same as a gap GD2 between the second opening PDLop1ba and the fourth opening PDLop2a. Further, a distance DT1 between a center of the first light emitting region PXA-B and a center of the first sensing region SA may be substantially the same as a distance DT2 between a center of the second light emitting region PXA-Ba and a center of the second sensing region SA-dm.

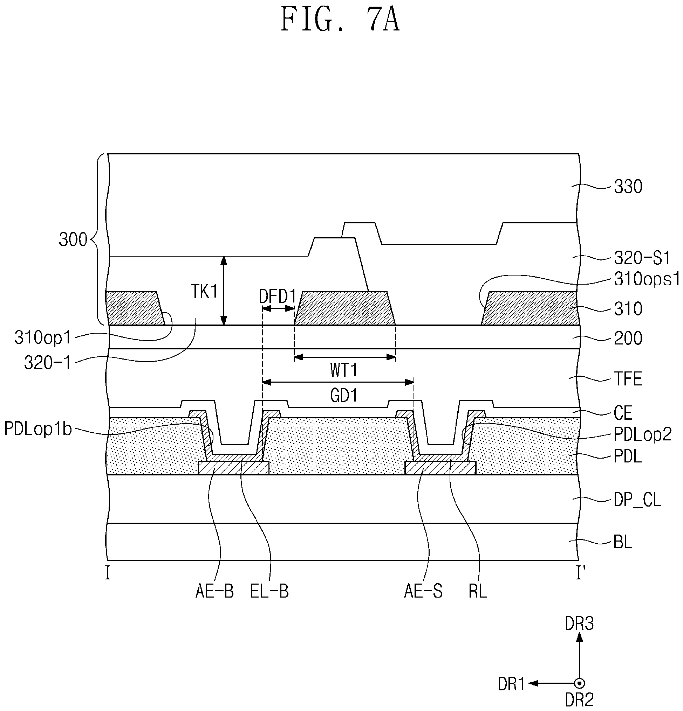

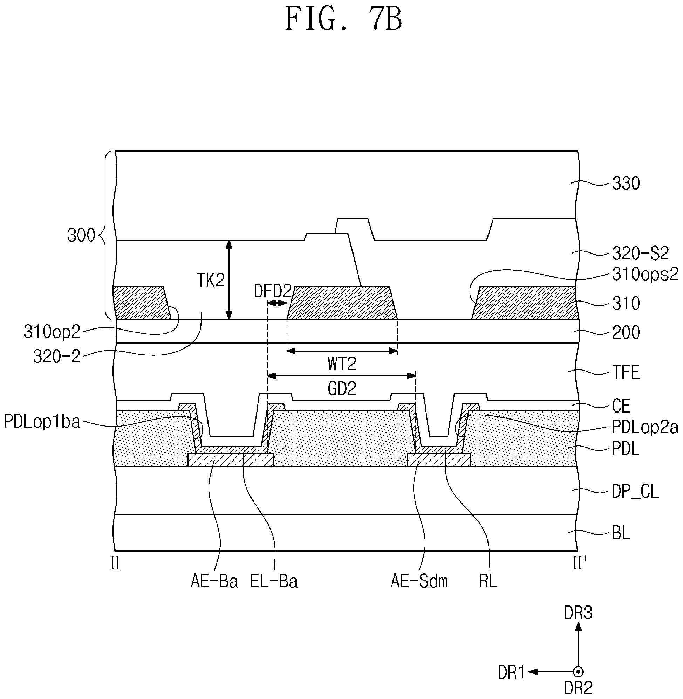

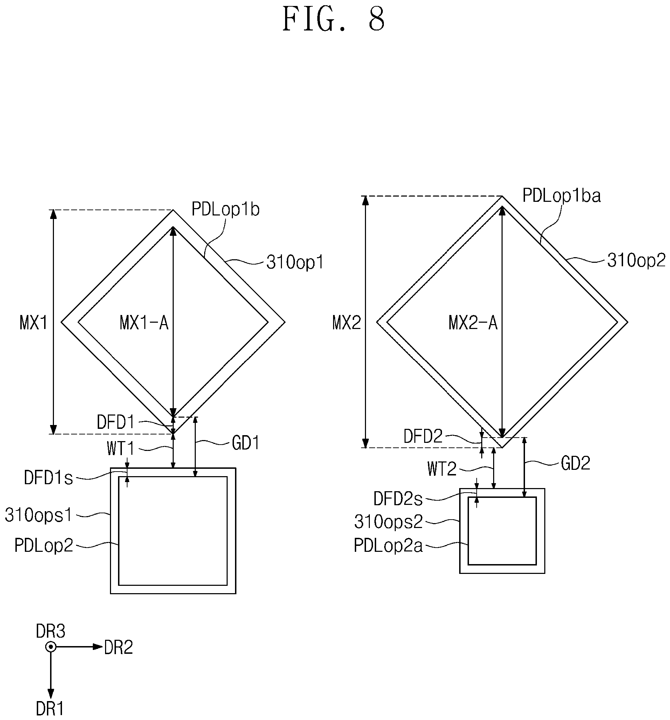

FIG. 7A is a schematic cross-sectional view of the electronic device 1000 according to an embodiment of the present disclosure. FIG. 7B is a schematic cross-sectional view of the electronic device 1000 according to an embodiment of the present disclosure. FIG. 8 is a plan view of components of the electronic device 1000 according to an embodiment of the present disclosure. For example, FIG. 7A is a cross-sectional view taking along line I-I' illustrated in FIG. 6A, and FIG. 7B is a cross-sectional view taking along line II-II' illustrated in FIG. 6B.

Referring to FIGS. 7A, 7B, and 8, the reflection prevention layer 300 may include the division layer 310. A first division opening 310op1, a second division opening 310op2, a third division opening 310ops1, and a fourth division opening 310ops2 may be defined (provided or formed) in the division layer 310. The first division opening 310op1, the second division opening 310op2, the third division opening 310ops1, and the fourth division opening 310ops2 may overlap the first opening PDLop1b, the second opening PDLop1ba, the third opening PDLop2, and the fourth opening PDLop2a in one-to-one correspondence.

The reflection prevention layer 300 may include a first color filter 320-1, a second color filter 320-2, a third color filter 320-S1, and a fourth color filter 320-S2 that cover the first division opening 310op1, the second division opening 310op2, the third division opening 310ops1, and the fourth division opening 310ops2 in one-to-one correspondence.

In an embodiment of the present disclosure, a first difference DFD1 may be half of the difference between a maximum width MX1 of the first division opening 310op1 and a maximum width MX1-A of the first opening PDLop1b. A second difference DFD2 may be half of the difference between a maximum width MX2 of the second division opening 310op2 and a maximum width MX2-A of the second opening PDLop1ba. The first difference DFD1 may be greater than the second difference DFD2. In this case, a first width WT1 of the division layer 310 between the first division opening 310op1 and the third division opening 310ops1 may be smaller than a second width WT2 of the division layer 310 between the second division opening 310op2 and the fourth division opening 310ops2.

In an embodiment of the present disclosure, as a size of the first division opening 310op1 is adjusted, a thickness TK1 of the first color filter 320-1 may be smaller than a second thickness TK2 of the second color filter 320-2. Thus, light transmittance of the first color filter 320-1 may be higher than light transmittance of the second color filter 320-2. In this case, assuming that a light having the same intensity is output, brightness of a light output from the first light emitting layer EL-B may be higher than brightness of a light output from a second light emitting layer EL-Ba. In this case, when an image having the same brightness is expressed, a current provided to the first light emitting element ED1 including the first light emitting layer EL-B may be smaller than a current provided to the second light emitting element ED2 including the second light emitting layer EL-Ba.

According to an embodiment of the present disclosure, even when the first light emitting layer EL-B has a smaller area than that of the second light emitting layer EL-Ba, the first thickness TK1 of the first color filter 320-1 is smaller than the second thickness TK2 of the second color filter 320-2, and thus light emitting efficiency of the first light emitting region PXA-B (see FIG. 6A) may be greater than light emitting efficiency of the second light emitting region PXA-Ba (see FIG. 6A). Thus, a difference between lifetimes of the first light emitting layer EL-B and the second light emitting layer EL-Ba due to a difference between the areas thereof may be reduced through a difference between the light emitting efficiencies thereof.

Thus, according to an embodiment of the present disclosure, the size of the third opening PDLop2 is greater than the size of the fourth opening PDLop2a defining the second sensing region SA-dm (see FIG. 6A), and thus fingerprint sensing sensitivity may be increased. Further, the difference between the lifetimes of the first light emitting layer EL-B and the second light emitting layer EL-Ba due to the difference between the areas thereof may be reduced as the first thickness TK1 of the first color filter 320-1 becomes smaller than the second thickness TK2 of the second color filter 320-2. Thus, fingerprint sensing sensitivity of the electronic device 1000 (see FIG. 1) may be increased, and a difference between lifetimes of the pixels PX (see FIG. 3) in the fingerprint sensing region FSA (see FIG. 3) and the fingerprint non-sensing region NFSA (see FIG. 3) may be reduced.

According to an embodiment of the present disclosure, a first difference DFD1s may be half of the difference between a width of the third division opening 310ops1 and a width of the third opening PDLop2. A second difference DFD2s may be half of the difference between a width of the fourth division opening 310ops2 and a width of the fourth opening PDLop2a. The first difference DFD1s may be substantially the same as the second difference DFD2s.Thus, the third opening PDLop2 may be greater than the fourth opening PDLop2a, and the third division opening 310ops1 may be greater than the fourth division opening 310ops2.

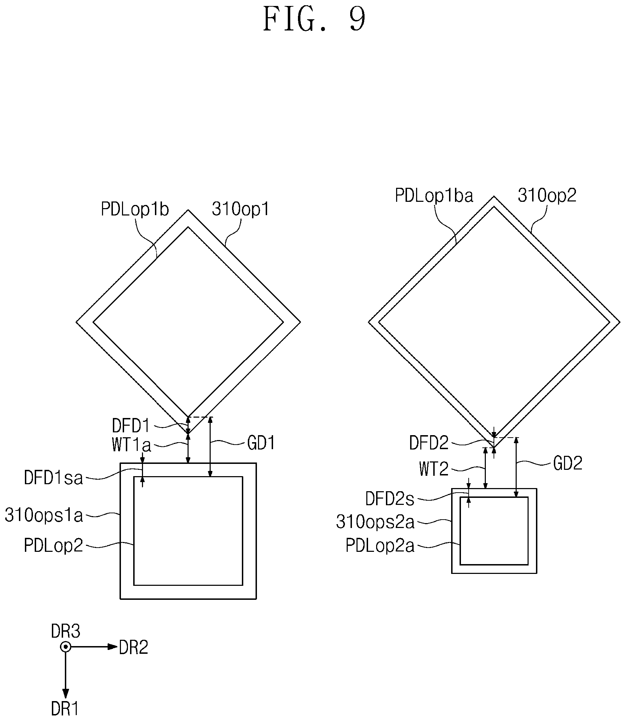

FIG. 9 is a plan view illustrating components of the electronic device 1000 according to an embodiment of the present disclosure.

Referring to FIG. 9, a first difference DFD1sa may be half of the difference between a width of a third division opening 310ops1a and the width of the third opening PDLop2. A second difference DFD2s may be half of the difference between a width of a fourth division opening 310ops2a and the width of the fourth opening PDLop2a. The first difference DFD1sa may be greater than the second difference DFD2s. The third opening PDLop2 may be greater than the fourth opening PDLop2a, and the third division opening 310ops1a may be greater than the fourth division opening 310ops2a.

A first width WT1a of the division layer 310 between the first division opening 310op1 and the third division opening 310ops1a may be smaller than the second width WT2 of the division layer 310 between the second division opening 310op2 and the fourth division opening 310ops2a.

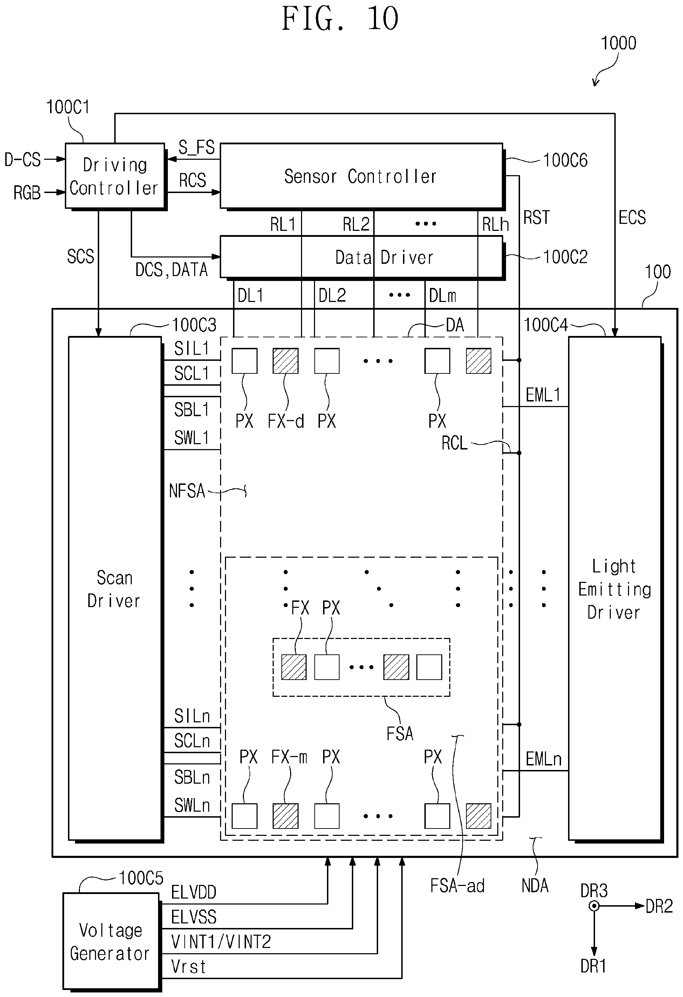

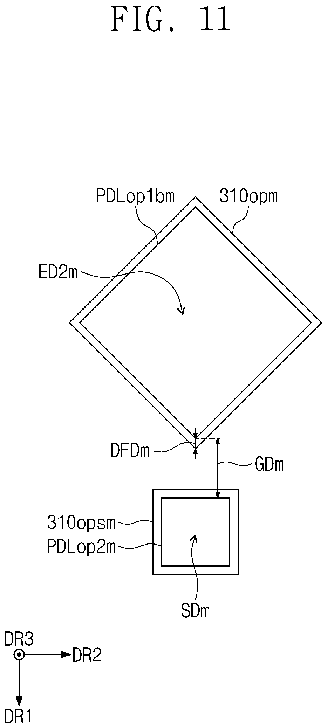

FIG. 10 is a block diagram illustrating the display layer 100 and the display driver 100C according to an embodiment of the present disclosure. FIG. 11 is a plan view of components of the electronic device 1000 according to an embodiment of the present disclosure.

Referring to FIGS. 10 and 11, the display region DA may include the fingerprint sensing region FSA, an auxiliary fingerprint sensing region FSA-ad, and the fingerprint non-sensing region NFSA.

The display layer 100 may include the plurality of pixels PX arranged in the display region DA, the plurality of sensors FX arranged in the fingerprint sensing region FSA, a plurality of auxiliary sensors FX-m arranged in the auxiliary fingerprint sensing region FSA-ad, and the plurality of dummy sensors FX-d arranged in the fingerprint non-sensing region NFSA.

Referring to FIGS. 5A, 10, and 11, a third light emitting element ED2m and a third sensing element SDm may be arranged in the auxiliary fingerprint sensing region FSA-ad. The third light emitting element ED2m and the third sensing element SDm may have a cross-sectional structure similar to the cross-sectional structure described in FIG. 5A. A fifth opening PDLop1bm overlapping the third light emitting element ED2m and a sixth opening PDLop2m overlapping the third sensing element SDm may be defined in the pixel defining film PDL. A fifth division opening 310opm overlapping the fifth opening PDLop1bm and a sixth division opening 310opsm overlapping the sixth opening PDLop2m may be defined in the division layer 310.

According to an embodiment of the present disclosure, a difference DFDm may be half of the difference between a width of the fifth division opening 310opm and a width of the fifth opening PDLop1bm. A half of the difference between a width of the sixth division opening 310opsm and a width of the sixth opening PDLop2m may be substantially the same as the difference DFDm.

According to an embodiment of the present disclosure, sensitivity of the sensors FX required in the fingerprint sensing region FSA may be greater than sensitivity of the auxiliary sensors FX-m required in the auxiliary fingerprint sensing region FSA-ad. For example, the sixth opening PDLop2m may be smaller than the third opening PDLop2 (see FIG. 8) and greater than the fourth opening PDLop2a (see FIG. 8). Further, the sixth division opening 310opsm may be smaller than the third division opening 310ops1 (see FIG. 8) and greater than the fourth division opening 310ops2 (see FIG. 8).

In an embodiment of the present disclosure, a size of the fifth opening PDLop1bm defining an area of a light emitting region of the third light emitting element ED2m may be greater than a size of the first opening PDLop1b (see FIG. 6A) defining the first light emitting region PXA-B(see FIG. 6A) and smaller than a size of the second opening PDLop1ba (see FIG. 6A) defining the second light emitting region PXA-Ba (see FIG. 6A). Further, a gap GDm between the fifth opening PDLop1bm and the sixth opening PDLop2m may be substantially the same as the gap GD1 (see FIG. 8) between the first opening PDLop1b (see FIG. 8) and the third opening PDLop2 (see FIG. 8).

According to the above description, an area of a first sensing region of a fingerprint sensing region and an area of a second sensing region of a fingerprint non-sensing region may be different from each other. For example, the area of the first sensing region may be greater than the area of the second sensing region. Thus, an opening ratio of the first sensing region relatively increases, and thus fingerprint sensing sensitivity may be increased.

Further, as an area of the first sensing region increases, areas of a first light emitting layer disposed in the fingerprint sensing region and a second light emitting layer disposed in the fingerprint non-sensing region may be different from each other. A difference between lifetimes of the first light emitting layer and the second light emitting layer due to a difference between areas thereof may be reduced as a first thickness of a first color filter disposed on the first light emitting layer becomes smaller than a second thickness of a second color filter disposed on the second light emitting layer. When an image having the same brightness is expressed, a current provided to a first light emitting element including the first light emitting layer may be smaller than a current provided to a second light emitting element including the second light emitting layer. Thus, a difference between lifetimes of pixels in the fingerprint sensing region and the fingerprint non-sensing region may be reduced.

Although the description has been made above with reference to an embodiment of the present disclosure, it may be understood that those skilled in the art or those having ordinary knowledge in the art may variously modify and change the present disclosure without departing from the spirit and technical scope of the present disclosure.

## Claims

1. An electronic device (1000), comprising:
a display layer (100); and
a reflection prevention layer (300) disposed on the display layer (100),
wherein the display layer (100) includes:
a first light emitting element (ED1) having a first light emitting region (PXA-B);
a first sensing element (SD) adjacent to the first light emitting element (ED1) in a first direction (DR1) and having a first sensing region (SA);
a second light emitting element (ED2) having a second light emitting region (PXA-Ba); and
a second sensing element (SD-dm) adjacent to the second light emitting element (ED2) in the first direction (DR1) and having a second sensing
region (SA-dm), and
wherein an area of the first sensing region (SA) is greater than an area of the second sensing region (SA-dm) on a plane defined by the first direction (DR1) and a second
direction (DR2) intersecting the first direction (DR1).

2. The electronic device (1000) of claim 1, wherein an area of the first light emitting region (PXA-B) is smaller than an area of the second light emitting region (PXA-Ba).

3. The electronic device (1000) of claim 1, wherein the first light emitting element (ED1) includes a first pixel electrode (AE-B), the second light emitting element (ED2) includes a second pixel electrode (AE-Ba), the first sensing element (SD) includes a first sensor
electrode (AE-S), and the second sensing element (SD-dm) includes a second sensor electrode AE-Sdm), and
the display layer (100) further includes a pixel defining film (PDL) partially covering the first pixel electrode (AE-B), the second pixel electrode (AE-Ba), the first sensor electrode (AE-S), and the second sensor electrode(AE-Sdm) and including a first opening (PDLop1) overlapping the first pixel electrode (AE-B), a second opening (PDLop2) overlapping the second pixel electrode(AE-Ba), a third opening (PDLop1a) overlapping the first sensor electrode (AE-S), and a fourth opening (PDLop2a) overlapping the second sensor electrode (AE-Sdm).

4. The electronic device (1000) of claim 3, wherein a size of the first opening (PDLop1) is smaller than a size of the second opening (PDLop2) on the plane.

5. The electronic device (1000) of claim 3, wherein a size of the third opening (PDLop1a) is larger than a size of the fourth opening (PDLop2a) on the plane.

6. The electronic device (1000) of any one of claim 3 to 5, wherein a gap between the first opening (PDLop1) and the third opening (PDLop1a) is substantially the same as a gap between the second opening (PDLop2) and the fourth opening (PDLop2a).

7. The electronic device (1000) of any of the previous claims, wherein the first light emitting
region (PXA-B) is defined by the first opening (PDLop1), the second light emitting region (PXA-Ba) is defined by the second opening (PDLop2), the first sensing region (SA) is defined by the third opening (PDLop1a), and the second sensing region (SA-dm) is defined by the fourth opening (PDLop2a).

8. The electronic device (1000) of any of the previous claims, wherein the reflection prevention layer (300) includes a division layer (310) including a first division opening (310op1), a second division opening (310op2), a third division opening (310ops1, 310ops1a), and a fourth division opening (310ops2, 310ops2a) overlapping the first opening (PDLop1), the second opening (PDLop2), the third opening (PDLop1a), and the fourth opening (PDLop2a) in one-to-one correspondence.

9. The electronic device (1000) of claim 8, wherein a difference between a maximum width of the first division opening (310op1) and a maximum width of the first opening (PDLop1) is greater than a difference between a maximum width of the second division opening (310op2) and a maximum width of the second opening PDLop2).

10. The electronic device (1000) of claim 8, wherein a distance between the first division opening (310op1) and the third division opening (310ops1, 310ops1a) is smaller than a distance between the second division opening (310op2) and the fourth division opening (310ops2, 310ops2a).

11. The electronic device (1000) of claim 8, wherein the reflection prevention layer (300) further includes a first color filter (320-1) configured to cover the first division opening (310op1) and a second color filter (320-2) configured to cover the second division opening (310op2), and a thickness of the first color filter (320-1) is smaller than a thickness of the second color filter (320-2).

12. The electronic device (1000) of claim 1, wherein the first light emitting element (ED1 and the second light emitting element (ED2) output a light having the same color.

13. The electronic device (1000) of claim 1, wherein a distance between a center of the first light emitting region (PXA-B) and a center of the first sensing region (SA) is substantially the same as a distance between a center of the second light emitting region (PXA-Ba) and a center of the second sensing region (SA-dm).

14. The electronic device (1000) of claim 1, wherein the display layer (100) further includes a sensor driving circuit electrically connected to the first sensing element (SD), and the second sensing element (SD-dm) is a dummy element.
